(19) Europäisches Patentamt / European Patent Office / Office européen des brevets

(11) **EP 2 034 324 A2**

(12) # EUROPEAN PATENT APPLICATION

(43) Date of publication:
**11.03.2009 Bulletin 2009/11**

(51) Int Cl.:
***G01R 33/09*** *(2006.01)*

(21) Application number: **07112836.7**

(22) Date of filing: **20.07.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Koninklijke Philips Electronics N.V.
5621 BA Eindhoven (NL)**

(72) Inventors:
• **The inventor has agreed to waive his entitlement to designation.**

(74) Representative: **Ledeboer, Johannes Albertus
Philips
Intellectual Property & Standards
P.O. Box 220
5600 AE Eindhoven (NL)**

(54) **Sensor cartridge**

(57)     The present invention provides a sensor cartridge (10) for distinctively determining at least two different target moieties in a fluid sample. The sensor cartridge (10) comprises a reaction chamber (1) and at least a first and second region (2, 3) distinct from each other. The first region (2) comprises magnetic or magnetizable objects (4a) labelled with a first type of probes for specifically binding a first type of target moieties and the second region (3) comprises magnetic or magnetizable objects (4b) labelled with a second type of probes for specifically binding a second type of target moieties, the magnetic or magnetizable objects (4a, 4b) in the first and second region (2, 3) being directly contactable by the sample fluid. The present invention also provides a method for the manufacturing of such sensor devices (10) and a method for determining the presence and/or amount of at least two different target moieties in a sample fluid using such sensor cartridge (10).

# FIG. 1

**Description**

FIELD OF THE INVENTION

The present invention relates to sensor cartridges, e.g. replaceable or disposable cartridges. More particularly, the present invention relates to sensor cartridges which can distinctively detect at least two different target moieties in a sample fluid. The present invention furthermore relates to a method for manufacturing such sensor cartridges and to a method for determining the presence and/or amount of at least two target moieties in a sample fluid. The device and methods according to embodiments of the invention can be used in molecular diagnostics, biological sample analysis or chemical sample analysis.

BACKGROUND OF THE INVENTION

Magnetic sensors based on AMR (anisotropic magneto resistance), GMR (giant magneto resistance) and TMR (tunnel magneto resistance) elements or on Hall sensors, are nowadays gaining importance. Besides the known high-speed applications such as magnetic hard disk heads and MRAM, new relatively low bandwidth applications appear in the field of molecular diagnostics (MDx), current sensing in IC's, automotive, etc.

The introduction of micro-arrays or biochips comprising such magnetic sensors is revolutionising the analysis of biomolecules such as DNA (desoxyribonucleic acid), RNA (ribonucleic acid) and proteins. Applications are, for example, human genotyping (e.g. in hospitals or by individual doctors or nurses), bacteriological screening, biological and pharmacological research. Such magnetic biochips have promising properties for, for example, biological or chemical sample analysis, in terms of sensitivity, specificity, integration, ease of use and costs.

Biochips, also called biosensor chips, biological microchips, gene-chips or DNA chips, consist in their simplest form of a substrate on which a large number of different probe molecules are attached, on well-defined regions on the chip, to which molecules or molecule fragments that are to be analysed can bind if they are perfectly matched. For example, a fragment of a DNA molecule binds to one unique complementary DNA (c-DNA) molecular fragment. The occurrence of a binding reaction can be detected, for example by using markers, e.g. fluorescent markers or magnetic labels, which are coupled to the molecules to be analysed, either before or after binding of these molecules to the probe molecules. This provides the ability to analyse small amounts of a large number of different molecules or molecular fragments in parallel, in a short time.

In a biosensor an assay takes place. Assays generally involve several fluid actuation steps, i.e. steps in which materials are brought into movement. Examples of such steps are mixing (e.g. for dilution, or for the dissolution of labels or other reagents into the sample fluid, or for labelling, or for affinity binding) or the refresh of fluid near to a reaction surface in order to avoid that diffusion becomes rate-limiting for the reaction. Preferably the actuation method should be effective, reliable and cheap.

One biochip can hold assays for 1000 or more different molecular fragments. It is expected that the usefulness of information that can become available from the use of biochips will increase rapidly during the coming decade, as a result of projects such as the Human Genome Project, and follow-up studies on the functions of genes and proteins.

A biosensor consisting of an array of, for example 100, sensors based on the detection of e.g. superparamagnetic beads may be used to simultaneously measure the concentration of a large number of different biological molecules (e.g. protein, DNA) in a solution (e.g. blood). This may be achieved by attaching a superparamagnetic bead to target molecules which are to be determined, magnetizing this bead with an applied magnetic field and using e.g. a Giant Magneto Resistance (GMR) sensor to detect the magnetic field of the magnetized beads.

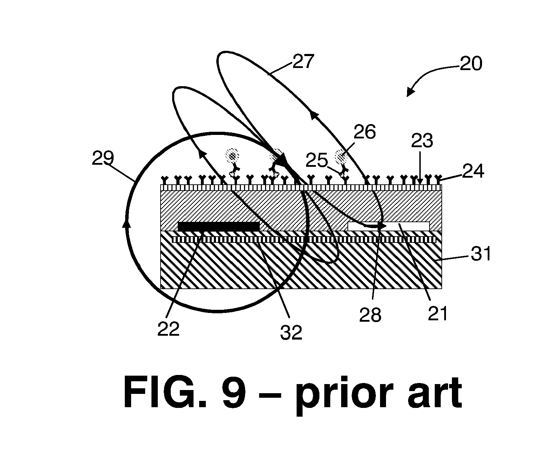

Fig. 9 illustrates the working principle of a magnetoresistive biosensor configuration with integrated magnetic field excitation as presently known in the art. The magnetic biosensor comprises a single GMR strip 21 with a length of about 100 $\mu$m and a width of about 3 $\mu$m. With integrated magnetic field excitation is meant that a magnetic field generating means is integrated in the magnetoresistive sensor 20. The magnetoresistive sensor 20 furthermore comprises a current wire 22 which forms the magnetic field generating means. At the surface 23 of the magnetoresistive sensor 20, binding sites 24 are provided to which, for example, target molecules 25 with attached thereto a magnetic nanoparticle 26, can bind. A current flowing through the current wire 22 generates a magnetic field 29 which magnetizes the magnetic nanoparticle 26. The magnetic nanoparticle 26 develops a magnetic moment m . The magnetic moment m then generates a dipolar magnetic field indicated by field lines 27 in Fig. 9, which have in-plane magnetic field components 28 at the location of the GMR strip 21. Thus, the magnetic nanoparticle 26 deflects the magnetic field 29 induced by the current through the current wire 22, resulting in the magnetic field component in the sensitive x-direction (indicated by reference number 28 in Fig. 9) of the GMR strip 21, also called x-component of the magnetic field $H_{ext}$. The x-component of the magnetic field $H_{ext}$ is then sensed by the GMR strip 21 and depends on the number $N_{np}$ of magnetic nanoparticles 26 present at the surface 23 of the magnetoresistive sensor 20 and on the magnitude of the current in the current wire 22. The magnetoresistive sensor 20 may be formed on a silicon chip 31 comprising electronics 32.

Target molecules such as e.g. illicit drugs are in general small molecules which are capable of binding only one capture molecule (antibody). For this reason an inhibition or competition assay format is used. There are several assays possible. In an assay of a first type, target homologue molecules are present on the sensor surface. These target homologue molecules compete with the target molecules to be detected in a sample fluid for binding to a capture molecule that is present on the magnetic beads. In a second type of assay, the magnetic bead is coated or labelled with the target homologue and the labelled bead competes with the target molecules to be detected in a sample fluid for binding to capture molecules (antibodies) that are present on the sensor surface. To be able to detect, for example, five different target molecules, five different capture molecules need to be present on the magnetic bead or on the sensor surface, depending on the assay format used. Furthermore five different target homologues need to be present on the sensor surface or on the magnetic bead, again depending on the assay format used. For small target molecules the binding to other molecules via a receptor-ligand binding (e.g. binding to an antibody) is generally not very specific. As a result, cross-reaction may occur or, in other words, a magnetic bead coated or labelled with binding molecules for type A may bind to a target homologue of type B. It has, for example, been shown that adding magnetic beads with anti-opiate (anti OPI) antibodies to a sensor array with at least one sensor coated with opiate homologues (BSA-OPI conjugate) and one sensor coated with, for example, cannabis homologue (BSA-THC conjugate) will show a large sensor output for the sensor coated with BSA-OPI, but may also show a significant output signal for the sensor coated with BSA-THC. This signal may be up to 5-10% of the specific signal on the sensor coated with opiate homologue.

To minimise the amount of cross-reactivity, the assay may be tuned. This can be done by choosing a right combination of antibodies and/or target homologues and by optimising the buffer in which incubation takes place. This optimisation is, however, a tedious process which is difficult to perform and which requires a lot of time and a lot of knowledge on different assays.

SUMMARY OF THE INVENTION

It is an object of embodiments of the present invention to provide a good sensor cartridge, a method for the manufacturing of such a sensor cartridge and a method for detecting and/or quantifying at least two different target moieties present in a same sample fluid.

The above objective is accomplished by a method and device according to the present invention.

A sensor cartridge in accordance with embodiments of the present invention can be a replaceable or disposable (one-way) cartridge. The sensor cartridge according to embodiments of the present invention allows detecting the presence and/or determining the amount of at least two different target moieties in a same fluid sample substantially without cross-reaction of the different target moieties with different target homologues present at a sensor substrate surface negatively influencing the resulting sensor signal. Hence, the device and method according to embodiments of the invention show reduced cross-reactivity.

The sensor cartridge according to embodiments of the present invention shows a good sensitivity and is reliable and effective.

The sensor cartridge and method according to embodiments of the present invention may be used in molecular diagnostics, biological sample analysis or chemical sample analysis.

Particular and preferred aspects of the invention are set out in the accompanying independent and dependent claims. Features from the dependent claims may be combined with features of the independent claims and with features of other dependent claims as appropriate and not merely as explicitly set out in the claims.

In a first aspect of the invention, a sensor cartridge is provided for determining the presence and/or amount of at least two different target moieties present in a sample fluid. The sensor cartridge comprises:

- a reaction chamber for receiving the sample fluid,
- at least a first region and a second region located in the reaction chamber, the second region being distinct from the first region, the first region comprising magnetic or magnetizable objects labelled with a first type of probes for specifically binding a first type of target moieties and the second region comprising magnetic or magnetizable objects labelled with a second type of probes for specifically binding a second type of target moieties, the magnetic or magnetizable objects in the first and second region being directly contactable by the sample fluid, and
- at least one sensor element for sensing the presence of magnetic or magnetizable objects,

wherein the sensor cartridge is adapted for distinctively detecting the at least two different target moieties.

An advantage of the sensor cartridge according to embodiments of the present invention is that it may be used to simultaneously detect different target moieties present in a sample fluid without signals originating from cross-reaction disturbing the sensor signal.

The sensor cartridge may comprise control means for selectively releasing labelled magnetic or magnetizable objects from the at least first and second region in the reaction chamber. Preferably, the control means may be formed by a magnetic field generating means and may, for example, be formed by at least one current wire. By carefully steering the control means the magnetic or magnetizable objects may be controllably and selectively released from the first and second region and therefore, the possibility for cross-reactions to occur may be decreased.

According to embodiments of the invention, the sensor cartridge may comprise a plurality of regions and a control means may be provided for each region.

The at least one sensor element may be located at a first side of the reaction chamber and the at least first and second region comprising magnetic or magnetizable objects may be formed at a second side of the reaction chamber, the second side preferably being substantially opposite to the first side.

The sensor cartridge may comprise a number of regions comprising magnetic or magnetizable objects and a number of sensor elements. According to embodiments of the invention, the number of regions may be different from the number of sensor elements. However, according to other embodiments of the invention, the number of regions may be equal to the number of sensor elements.

According to embodiments, the sensor elements may be lying in a plane, and each of the regions comprising magnetic or magnetizable objects may show an overlap with a respective sensor element, the overlap being defined by the projection of the regions onto the sensor elements in a direction substantially perpendicular to the plane of the sensor elements.

According to still other embodiments, the at least one sensor element may be located at a first side of the reaction chamber and the at least first and second region may be formed at a second side of the reaction chamber, the second side being equal to the first side.

The sensor cartridge may comprise at least a first and second sensor element. The first region comprising magnetic or magnetizable objects may be formed above the first sensor element and the second region comprising magnetic or magnetizable objects may be formed above the second sensor element.

According to embodiments of the invention, the labelled magnetic or magnetizable objects in the at least first and second region may be lyophilised.

In the sensor cartridge according to embodiments of the invention, the at least one sensor element may be located in a sensor substrate and the sensor cartridge may furthermore comprise magnetic field generating means for attracting and/or binding the labelled magnetic or magnetizable objects to the surface of the sensor substrate. The magnetic field generating means may be formed by a coil.

According to embodiments of the invention, the sensor cartridge may be a disposable sensor cartridge.

The disposable cartridge may be adapted for being inserted in a reader device. The reader device may comprise magnetic field generating means for attracting and releasing magnetic or magnetizable objects located in different regions of the disposable sensor cartridge in a controlled way. The magnetic field generating means may be formed by an electromagnetic coil.

In a further aspect, the present invention provides the use of a sensor cartridge according to embodiments of the invention in molecular diagnostics, biological sample analysis or chemical sample analysis.

The present invention also provides the use of a sensor cartridge according to embodiments of the invention for determining the presence of drugs-of-abuse in saliva.

In another aspect of the present invention, a method is provided for manufacturing a sensor cartridge. The method comprises:

- providing a reaction chamber for receiving a sample fluid,
- providing at least a first region and a second region in the reaction chamber, and
- providing magnetic or magnetizable objects labelled with a first type of probes for specifically binding a first type of target moieties to the first region and providing magnetic or magnetizable objects labelled with a second type of probes for specifically binding a second type of target moieties to the second region, and
- providing at least one sensor element for sensing the presence of magnetic or magnetizable objects.

An advantage of the method according to embodiments of the present invention is that different target moieties present in a sample fluid can be detected simultaneously without signals originating from cross-reactions disturbing the sensor signal.

According to embodiments of the invention, the method may furthermore comprise providing control means for selectively releasing labelled magnetic or magnetizable objects from the at least first and second region in the reaction chamber. According to embodiments of the invention, providing control means may comprise providing a control means for each of the at least first and second regions. By carefully steering the control means the magnetic or magnetizable objects may be controllably and selectively released from the first and second region and therefore, the possibility for cross-reactions to occur may be decreased.

According to embodiments of the invention, the sensor cartridge may comprise at least a first and a second sensor element lying in a plane and providing at least a first region and a second region in the reaction chamber may be such that the first and second region show an overlap with respectively the first and second sensor element, the overlap being defined by the projection of the first and second regions onto the sensor elements in a direction substantially perpendicular to the plane of the sensor elements.

According to embodiments of the invention, providing magnetic or magnetizable objects may be performed by providing lyophilised magnetic or magnetizable objects.

In still a further aspect of the invention, a method is provided for determining the presence and/or amount of at least two different target moieties in a sample fluid. The method comprises:

- providing a sample fluid potentially comprising at least two different target moieties to a sensor cartridge comprising a reaction chamber for receiving the sample fluid, at least one sensor element located in a sensor substrate for sensing the presence of magnetic or magnetizable objects and at least a first region and a second region located in the reaction chamber, the second region being distinct from the first region, the first region comprising magnetic or magnetizable objects labelled with a first type of probes for specifically binding a first type of target moieties and the second region comprising magnetic or magnetizable objects labelled with a second type of probes for specifically binding a second type of target moieties, the magnetic or magnetizable objects in the first and second region being directly contactable by the sample fluid,
- selectively providing labelled magnetic or magnetizable objects from the at least first and second region to the at least one sensor element,
- measuring a sensor signal by means of the at least one sensor element, and
- from the measured sensor signal distinctively determining the presence and/or amount of the at least two different target moieties bound to a surface of the sensor substrate.

Selectively providing labelled magnetic or magnetizable objects from the at least first and second region to the at least one sensor element may be obtained by selectively releasing labelled magnetic or magnetizable objects from the at least first and second region in the reaction chamber.

According to embodiments of the invention, the sensor cartridge may comprise a same number of regions as it comprises sensor elements and the sensor elements may be lying in a plane. According to these embodiments, selectively providing labelled magnetic or magnetizable objects from the at least first and second region to the sensor elements may be obtained by each region having an overlap with a different sensor element, the overlap being defined by the projection of the first and second regions onto the sensor elements in a direction substantially perpendicular to the plane of the sensor elements.

According to embodiments of the invention, the sensor cartridge may comprise a magnetic sensor element and the method may furthermore comprise, before measuring a sensor signal by means of the at least one sensor element, magnetising the labelled magnetic or magnetizable objects.

In yet a further aspect, the present invention provides the use of the method according to embodiments of the invention in molecular diagnostics, biological sample analysis or chemical sample analysis.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

BRIEF DESCRIPTION OF THE DRAWINGS

Fig. 1 illustrates a cross-section of a sensor cartridge according to an embodiment of the present invention.
Fig. 2 illustrates a cross-section of a sensor cartridge according to another embodiment of the present invention.
Fig. 3 (cross-section) and Fig. 4 (top view) illustrate the principle of a sensor cartridge according to embodiments of the present invention.
Fig. 5 illustrates a sensor cartridge according to an embodiment of the present invention.
Fig. 6 illustrates a sensor cartridge (right figure), a sensor substrate comprising four GMR elements (middle figure) and a part of the sensor substrate comprising one GMR element.
Fig. 7 illustrates a sensor cartridge according to an embodiment of the present invention.
Fig. 8 shows images at different time instants of bead redispersion with and without magnetic retention fields.
Fig. 9 illustrates the principle of a known magnetic biosensor. In the different figures, the same reference signs refer to the same or analogous elements.

DETAILED DESCRIPTION OF THE EMBODIMENTS

The present invention will be described with respect to particular embodiments and with reference to certain drawings but the invention is not limited thereto but only by the claims. Any reference signs in the claims shall not be construed as limiting the scope. The drawings described are only schematic and are non-limiting. In the drawings, the size of some of the elements may be exaggerated and not drawn on scale for illustrative purposes.

Where the term "comprising" is used in the present description and claims, it does not exclude other elements or steps. Where an indefinite or definite article is used when referring to a singular noun e.g. "a" or "an", "the", this includes a plural of that noun unless something else is specifically stated.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practised without these specific details. In other instances, well-known methods, structures and techniques have not been shown in detail in order not to obscure an understanding of this description.

The following terms or definitions are provided solely to aid in the understanding of the invention. The definitions should not be construed to have a scope less than understood by a person of ordinary skill in the art.

The term "probe" relates in the present invention to a binding molecule that specifically binds a target moiety. Probes envisaged within the context of the present invention include biologically-active moieties such as but not limited to whole anti-bodies, antibody fragments such as Fab' fragments, single chain Fv, single variable domains, VHH, heavy chain antibodies, peptides, epitopes, membrane receptors or any type of receptor or a portion thereof, substrate-trapping enzyme mutants, whole antigenic molecules (haptens) or antigenic fragments, oligopeptides, oligonucleotides, mimitopes, nucleic acids and/or mixture thereof, capable of selectively binding to a potential target moiety. Antibodies can be raised to non-proteinaceous compounds as well as to proteins or peptides. Probes are typically members of immunoreactive or affinity reactive members of binding-pairs. The nature of the probe is determined by the nature of the target moiety to be detected. Most commonly, the probe is developed based on a specific interaction with the target moiety such as, but not limited to, antigen-antibody binding, complementary nucleotide sequences, carbohydrate-lectin, complementary peptide sequences, ligand-receptor, coenzyme, enzyme inhibitors-enzyme, etc. In the present invention, the function of a probe is specifically interact with a target moiety to permit its detection. Therefore, the probes are attached to magnetic or magnetizable objects such as magnetic particles. The probe can be an anti-analyte antibody if, for instance, the target moiety is a protein. Alternatively, the probe can be a complementary oligonucleotide sequence if, for instance, the target moiety is a nucleotide sequence.

In a first aspect of the invention a sensor cartridge is provided for determining the presence and/or amount of at least two different target moieties in a sample fluid. The sensor cartridge comprises a reaction chamber for receiving the sample fluid and at least a first region and a second region located in the reaction chamber, the second region being distinct from the first region. The first region comprises magnetic or magnetizable objects labelled with a first type of probes for specifically binding a first type of target moieties and the second region comprises magnetic or magnetizable objects labelled with a second type of probes for specifically binding a second type of target moieties, the magnetic or magnetizable objects in the first and second region being directly contactable by the sample fluid at a same moment in time. The sensor cartridge furthermore comprises at least one sensor element for sensing the presence of magnetic or magnetizable objects. According to the present invention the sensor cartridge is adapted for distinctively detecting the at least two different target moieties. With distinctively detecting is meant that the at least two different target moieties are detected at a different location and/or at a different period in time. A cartridge according to any of the embodiments of the present invention may be a replaceable or a disposable (one-way) cartridge.

The sensor cartridge according to embodiments of the present invention allows detecting the presence and/or determining the amount of at least two different target moieties in a same fluid sample substantially without cross-reaction of the different target moieties with different target homologues negatively influencing the resulting sensor signal. With cross-reaction is meant that, when magnetic or magnetizable objects of type A should specifically bind to target homologues of type A present on the sensor substrate surface and magnetic or magnetizable objects of type B should specifically bind to target homologues of type B present on the sensor substrate surface, that also magnetic or magnetizable objects of type A bind to target homologues of type B and/or vice versa, which leads to a distorted result. As such cross-reactions are reduced or even avoided in accordance with the present invention, the sensor cartridge according to embodiments of the present invention is reliable and effective.

The sensor cartridge according to embodiments of the present invention can, for example, be used in molecular diagnostics, biological sample analysis or chemical sample analysis for, for example, detecting and/or quantifying target moieties present in a sample fluid and labelled with magnetic and/or magnetizable objects. Target moieties may include molecular species, cell fragments, viruses, etc.

Detection of magnetic labels can be done based on their magnetic properties. Alternatively, the magnetic labels can be detected based on other physical properties. The present invention will further be described by means of a sensor cartridge based on magnetoresistive elements such as GMR elements as magnetic sensor elements. However, this is not intended to limit the invention in any way. The present invention may be applied to sensor cartridges comprising any sensor element suitable for detecting the presence or determining the amount of magnetic or magnetizable objects, e.g. magnetic particles, on or near a sensor substrate surface based on any property of the particles. For example, detection of the particles may be done by means of magnetic methods (e.g. magnetoresistive sensor elements, hall sensors, coils), optical methods (e.g. imaging fluorescence, chemiluminescence, absorption, scattering, surface plasmon resonance, Raman, via an evanescent wave leading to frustrated total internal reflecion, ...), sonic detection (e.g. surface acoustic wave, bulk acoustic wave, cantilever, quartz crystal, ...), electrical detection (e.g. conduction, impedance, amperometric, redox cycling), mechanical detection (e.g. via shift in resonance peaks or damping of surface acoustic waves), .... The present invention is not limited to any of the above detection methods for detection of the magnetic labels, but can be used in combination with any other method for magnetic label detection.

According to embodiments of the invention, the surface of the sensor cartridge may be modified by a coating which is designed to bind certain target moieties or may be modified by attaching molecules, also referred to as target homologues, to it which are suitable to bind the probe-coated magnetic labels which are dispersed in the sample fluid to be tested. In this way the surface of the sensor cartridge, or at least part thereof, is activated with such binding molecules to form specific binding sites to enable immobilisation of target moieties. Such binding molecules are known to the skilled person and may include proteins, antibodies, nucleic acids (e.g. DNA, RNA), peptides, oligo- or polysaccharides or sugars, small molecules, hormones, drugs, metabolites, cells or cell fractions, tissue fractions, .... Such molecules may be attached to the sensor substrate surface by means of spacer or linker molecules. Binding sites on sensor substrate surfaces can also be provided with molecules in the form of organisms (e.g. viruses or cells) or fractions of organisms (e.g. tissue fractions, cell fractions, membranes).

Target moieties are to be detected in a sample fluid, which can be the original sample or can already have been processed before insertion into the sensor device (e.g. diluted, digested, degraded, biochemically modified, filtered, dissolved into a buffer). The original fluids can be, for example, biological fluids such as saliva, sputum, blood, blood plasma, cells, interstitial fluid or urine, or other fluids such as drinking fluids, environmental fluids, or a fluid that results from sample pre-treatment. The fluid can, for example, comprise elements of solid sample material, e.g. from biopsies, stool, food, feed, environmental samples.

The sensor cartridge in accordance with embodiments of the present invention may furthermore comprise a magnetic field generator. The magnetic field generator may be an internal or an external magnetic field generator. In this latter case, the magnetic field generator may be located in a reader device suitable for inserting the sensor cartridge. Alternatively, the magnetic field generator may be an internal magnetic field generator. The magnetic field generator may, for example, comprise at least one conductor such as e.g. at least two current wires or may be formed by an actuation coil. The magnetic field generator can be used for magnetizing the magnetic or magnetizable objects in the first and second regions of the reaction chamber of the sensor device, e.g. bound to a surface of the sensor substrate of the sensor cartridge, and attached to target moieties to be detected. The magnetic or magnetizable objects are preferably magnetic nanoparticles, but may also be any other suitable magnetizable objects which can be attached to target moieties. The present invention will further be described by means of the magnetic or magnetizable objects being magnetic particles. Again, this is only for the ease of explanation and it does not limit the invention in any way. The magnetic or magnetizable particles may include any suitable form of one or more magnetic particles or magnetizable particles e.g. magnetic, diamagnetic, paramagnetic, superparamagnetic, ferromagnetic, that is any form of magnetism which generates a magnetic moment in a magnetic field, either permanently or temporarily. Preferably, superparamagnetic particles are used since their use avoids possible aggregation problems that can occur when permanent magnets are used. An example of a suitable magnetic particle material is, for example, $Fe_3O_4$. The size of the magnetic particle is not critical in most embodiments but preferably the magnetic particles may have a longest dimension in the range of between 5 nm and 5000 nm, more preferably of between 30 nm and 1000 nm, most preferably of between 80 nm and 500 nm.

The present invention applies for a magnetic or magnetizable object being a magnetic rod, a string of magnetic particles, or a composite particle, e.g. a particle containing magnetic as well as non-magnetic material, for example optically-active material, or magnetic material inside a non-magnetic matrix.

Unless specified otherwise, the terms magnetic or magnetizable particles refer to particles, molecules or materials as such, not covalently linked to a probe. Where in the description is referred to types of magnetic particles, e.g. first, second, etc. type of magnetic particles, the magnetic particle linked to or coated with a type of probe for specifically binding to respectively a first, second, etc. type of target moiety is meant.

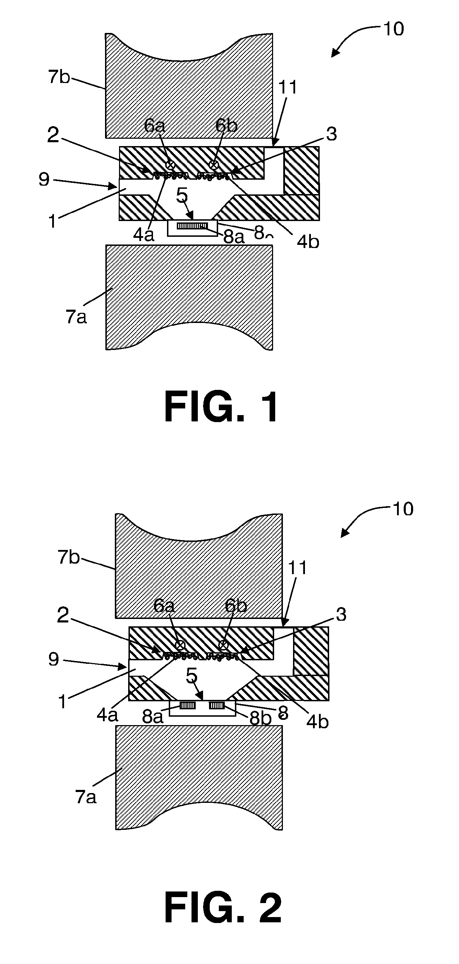

Fig. 1 illustrates a sensor cartridge 10 according to a first embodiment of the present invention. The sensor cartridge 10 comprises a reaction chamber 1. The reaction chamber 1 is for receiving a sample fluid to be tested, the sample fluid comprising at least two different target moieties. The reaction chamber 1 may, according to this embodiment, comprise a first region 2 and a second region 3, the second region 3 being distinct from the first region 2. It is to be noted that the scope of the invention is not limited to only two distinct regions. Any number of regions larger than or equal to 2 is within the scope of the present invention. The first region 2 comprises a first type of magnetic particles, i.e. magnetic particles 4a labelled with a first type of probes (not shown) for specifically binding the magnetic particles 4a to a first type of target moieties and thus for specifically binding them to a first type of target homologues which may be present at the surface 5 of a sensor substrate 8. The magnetic particles 4a labelled with the first type of probes will further be referred to as the first type of magnetic particles 4a. The second region 3 comprises a second type of magnetic particles, i.e. magnetic particles 4b labelled with a second type of probes (not shown) for specifically binding the magnetic particles 4b to a second type of target moieties and thus for specifically binding them to a second type of target homologues which may be present at the surface 5 of the sensor substrate 8. These magnetic particles 4b labelled with the second type of probes will further be referred to as the second type of magnetic particles 4b.

The term "substrate" used in the description may include any underlying material or materials that may be used, or upon which a device, a circuit or an epitaxial layer may be formed. The term "substrate" may include a semiconductor substrate such as e.g. a doped silicon, a gallium arsenide (GaAs), a gallium arsenide phosphide (GaAsP), an indium phosphide (InP), a germanium (Ge), or a silicon germanium (SiGe) substrate. The "substrate" may include, for example, an insulating layer such as a $SiO_2$ or a $Si_3N_4$ layer in addition to a semiconductor substrate portion. Thus the term "substrate" also includes glass, plastic, ceramic, silicon-on-glass, silicon-on-sapphire substrates. The term "substrate" is thus used to define generally the elements for layers that underlie a layer or portions of interest. Also the "substrate" may be any other base on which a layer is formed, for example a glass or metal layer.

According to this first embodiment and as can be seen from Fig. 1, the first and second regions 2, 3 and thus the first and second type of magnetic particles 4a, 4b, may be provided at a first side of the reaction chamber 1 and the sensor substrate 8 comprising a magnetic sensor element, such as e.g. GMR element 8a may be provided at a second side of the reaction chamber 1, the first and second side being substantially opposite to each other with respect to a center point or center line of the reaction chamber 1.

The first and second type of magnetic particles 4a, 4b may most preferably be provided in a lyophilised form, i.e. dried by freezing for example in vacuum, and may furthermore comprise an organic moiety, e.g. matrix component. The first and second type of lyophilised magnetic particles 4a, 4b may have a variety of morphologies and shapes. Lyophilisation or freeze-drying results in a lowered reactivity of the first and second type of magnetic particles 4a, 4b, thus resulting in a longer shelf life, i.e. improved storing properties. The first and second type of magnetic particles 4a, 4b may be stored in a separate recipient or may be stored incorporated in corresponding sensor cartridges or parts thereof. Exemplary shapes include spherical, near spherical, elliptical or round structures. According to the present invention, the first and second type of magnetic particles 4a, 4b may be droplet shaped. Exemplary morphologies include smooth or roughened surfaces. The first and second type of lyophilised magnetic particles 4a, 4b may, for example, have a diameter of between 10 $\mu$m and 300 $\mu$m. The size dispersity of the first and second type of lyophilised magnetic particles 4a, 4b is preferably substantially monodisperse, i.e. within a few percents, preferably less than 5%, even more preferred less than 1%. The first and second type of magnetic particles 4a, 4b may be made by monodispersion, resulting in first or second type of magnetic particles 4a, 4b having a substantially uniform shape and size.

According to embodiments of the invention, the organic moiety, e.g. matrix component, may comprise one or more sugars, one or more proteins or one or more polymers. Optionally, the organic moiety, e.g. matrix component, may comprise one or more salts. Such sugars may e.g. be selected from the group consisting of polyols, monosaccharides, disaccharides, oligosaccharides and polysacharides. For instance, they can be selected from sucrose, glucose, trehalose, melezitose, dextran or mannitol among others. Preferably, the one or more sugars that may be part of the matrix component may be selected from the group consisting of polyols, disaccharides and oligosaccharides. According to some embodiments, trehalose, mannitol or mixture thereof are used. One function of the one or more sugars may be to form a water-soluble and relatively amorphous matrix component. An amorphous matrix component permits a faster dissolution (see further) than a crystalline matrix component, thus assisting in providing first and second type of magnetic particles 4a, 4b that are preferred if fast availability of the bio-reagents is preferred or required. An advantage of using such first and second types of lyophilised magnetic particles 4a, 4b is that faster mixing occurs between the sample fluid and the probes than would occur when the probes would be delivered as fluid. Another advantage is that no additional fluids are needed to carry out the assay. This reduces the costs of the sensor cartridge 10 and the number of handling steps by the operator.

As indicated above, optionally one or more salts may be part of the organic moiety, e.g. matrix component. The one or more salts may, for example, be KCl and/or NaCl. Optionally, furthermore one or more proteins may be comprised in the organic moiety, e.g. matrix component. Examples of proteins that can be comprised into the composition of the organic moiety, e.g. matrix component, comprise but are not limited to Bovin Serum Albumin (BSA), gelatine, and collagen, among others. The proteins will stabilise the probes and will have a positive effect on the shelf-life of the first and second type of lyophilised magnetic particles 4a, 4b.

The first and second type of lyophilized magnetic particles 4a, 4b may be formed by, for example, dropping a solution containing the constituents of respectively the first and second type of lyophilized magnetic particles 4a, 4b in a freezing medium, followed by freeze drying the obtained frozen sphere containing the first and second type of magnetic particles 4a, 4b. The first and second type of lyophilized magnetic particles 4a, 4b may be provided to respectively the first and second region 2, 3 by any suitable micro-deposition technique such as mechanical positioning (in case of pre-formed lyophilized spheres), spotting, pipetting or printing (e.g. ink-jet printing).

According to other embodiments of the present invention, instead of being in lyophilized form, the first and second type of magnetic particles 4a, 4b may be comprised in a porous material, e.g. it forms a porous layer. Hence, a porous layer comprising the first type of magnetic particles 4a may be provided to the first region 2 and a porous layer comprising the second type of magnetic particles 4b may be provided to the second region 3. This may be obtained by depositing a layer of the first or second type of magnetic particles 4a, 4b which furthermore comprises material that sublimes during drying of the layer, such as, for example, water and/or a salt such as ammonium carbonate. The porous layer thus obtained may be nano-porous or micro-porous. Porosity is advantageous as it assists in improving, during use of the sensor device, dissolving of the components for releasing the first and second type of magnetic particles 4a, 4b (see further).

According to still other embodiments, more than one layer comprising the first type of magnetic particles 4a and/or one or more layers comprising the second type of magnetic particles 4b can be deposited on top of each other in respectively the first region 2 and the second region 3.

The invention is not limited to magnetic particles 4a, 4b in a lyophilized form or comprised in a porous layer. The magnetic particles 4a, 4b can be present in any other suitable form that allows a long shelf lifetime. For example, the particles can be present in a simple dried sugar matrix.

The sensor cartridge 10 may furthermore comprise an inlet 9 for providing sample fluid to the reaction chamber 1 and an outlet 11 for removing the sample fluid from the reaction chamber 1 after a test has been performed. The outlet 11 can be a venting hole to avoid air inclusions in the reaction chamber.

According to the present invention, the sensor cartridge 10 is adapted for distinctively determining the presence and/or amount of first and second type of target moieties. According to this first embodiment of the invention distinct determination of the presence and/or amount of the first and second type of target moieties may be obtained by the presence of a control means for selectively releasing the first type of magnetic particles 4a and the second type of magnetic particles 4b from respectively the first region 2 and the second region 3 into the reaction chamber 1. A control means may be provided for each of the first and second regions 2, 3 and may comprise magnetic field generating means formed by, for example, a current wire. According to the first embodiment of the invention, illustrated in Fig. 1, a first current wire 6a may be provided for retaining and selectively releasing the first type of magnetic particles 4a from the first region 2 into the reaction chamber 1 and a second current wire 6b may be provided for retaining and selectively releasing the second type of magnetic particles 4b from the second region 3 into the reaction chamber 1.

When, according to the example described above, two different target moieties are to be detected in a sample fluid, for example in a biological fluid such as e.g. saliva, the first and second different types of magnetic particles 4a, 4b are present in or on respectively the first and second regions 2, 3 of the sensor cartridge 10. The first and second regions 2, 3 may be volumes in the wall of the reaction chamber 1, or may be areas on the wall of the reaction chamber 1. Alternatively the regions may be regions on the sensor surface 5 outside the actual detection region around sensor elements 8a, 8b. The biological fluid, e.g. saliva, flows into the reaction chamber 1 over the surface 5 of the sensor substrate 8. During the time when the biological fluid, e.g. saliva, flows, the control means, e.g. the current wires 6a, 6b are actuated by sending current through these current wires 6a, 6b for retaining the first and second type of magnetic particles 4a, 4b at respectively the first and second regions 2, 3 in the reaction chamber 1. When, according to embodiments of the invention, the first and second type of magnetic particles 4a, 4b are provided as lyophilised or freeze-dried magnetic particles 4a, 4b, e.g. in a sugar matrix or in the form of accu-spheres (produced by freeze-drying small aliquots from a large pool of magnetic particle solution e.g. by inkjet printing the magnetic particle solution in a volume of liquid nitrogen), the biological fluid, e.g. saliva, will, when making contact with the matrix comprising the lyophilised magnetic particles 4a, 4b, dissolve the matrix. The first and second type of magnetic particles 4a, 4b, however, will stay at the first region 2, respectively the second region 3 due to the control of the control means, e.g. the magnetic field generated by the current wires 6a, 6b. The first and second type of target moieties present in the biological fluid can then specifically react with respectively the first and second type of magnetic particles 4a, 4b at respectively the first and second region 2, 3 in the reaction chamber 1. After some time, the flow of biological fluid stops and the control means may be steered so as to release the first and second type of magnetic particles 4a, 4b from respectively the first and second region 4a, 4b, e.g. magnetic fields generated by the current wires 6a, 6b may be switched off. This may be done synchronously for the first and second regions 2, 3 or sequentially (see further). When the control means is steered to release the first and second types of magnetic particles 4a, 4b, e.g. flowing of current through the current wires 6a, 6b is switched off, a further magnetic field may be generated for attracting the first and second type of magnetic particles 4a, 4b with attached thereto respectively the first and second target moiety towards the sensor substrate surface 5 where they can bind to respectively a first and second type of target homologues. The magnetic field for attracting the magnetic particles 4a, 4b towards the sensor substrate surface 5 may be generated by an external magnetic field generation means, for example by actuation coil 7a as indicated in Fig. 1. A further magnetic coil 7b may be present to achieve a bound-free separation after incubation of the magnetic particles 4a, 4b on the sensor substrate surface 5 in a magnetic washing step, or in other words to remove non-specifically bound magnetic particles 4a, 4b from the sensor substrate surface 5. The magnetic field generated by actuation coils 7a, 7b may also magnetize the magnetic particles 4a, 4b. The magnetic particles 4a, 4b thereby develop a magnetic moment. The magnetic moment then generates dipolar magnetic fields, which have in-plane magnetic field components at the location of the sensor element, e.g. GMR element 8a present in the sensor substrate 8 integrated in the sensor cartridge 10. The magnetic particles 4a, 4b become magnetized by the magnetic field induced by the current through the actuation coils 7a, 7b, resulting in the magnetic field component in the sensitive x-direction of the sensor element, e.g. GMR element 8a, also called x-component of the magnetic field $H_{ext}$. The x-component of the magnetic field $H_{ext}$ is then sensed by the GMR element 8a present in the sensor substrate 8 and its amplitude depends on the number of magnetic particles 4a, 4b present at the surface 5 of the sensor substrate 8 at the location of the sensor element 8a.

According to another embodiment the magnetic field necessary to magnetize the magnetic particles 4a, 4b can be generated by sending a current through on-chip current wires, i.e. current wires located on or in the sensor substrate 8, that are part of the sensor element 8a. The advantage of this latter method is that high modulation frequencies, i.e. in the order of between 10 kHz and 100 MHz, preferably in the order of between 100 kHz and 10 MHz, for the magnetic field can be used in order to avoid a large 1/f noise component of the GMR sensor element 8a.

The release of the first and second type of magnetic particles 4a, 4b from respectively the first and second region 2, 3 may be done in a controlled way. Therefore, release of the first and second type of magnetic particles 4a, 4b from respectively the first and second region 2, 3 may be performed in a sequential way. This will be explained hereinafter.

According to embodiments of the invention, the sensor cartridge 10 may comprise a number of regions 2, 3 in the reaction chamber 1 which is different from the number of sensor elements, e.g. GMR elements 8a in the sensor substrate 8. According to these embodiments, different types of target homologues may be provided at the surface 5 of the sensor substrate 8 at the location of each of the sensor elements, e.g. GMR elements 8a.

In Fig. 1 an example is given in which the sensor cartridge 10 comprises a first and a second region 2, 3 and one sensor element, e.g. GMR element 8a. In the example given in Fig. 1, this means that two different target homologues may be provided at the sensor substrate surface 5 at the location of the sensor elements, e.g. GMR element 8a provided in the sensor substrate 8, because there are two regions 2, 3 comprising a first and second type of magnetic particles 4a, 4b for binding to a first and second target moiety but there is only one GMR element 8a.

Hence, first the first type of magnetic particles 4a may be released from the first region 2 by appropriately steering the control means, e.g. by switching off the magnetic field generated by current wire 6a. The first magnetic particles 4a with attached thereto the first target moiety may then be attracted toward the sensor substrate surface 5 to bind to respective target homologues at the sensor substrate surface 5 and may be actuated by means of a magnetic field generated by the actuation coils 7a, 7b, or alternatively by on-chip current wires. At the sensor substrate surface 5, the first magnetic particles 4a with attached thereto the first type of target moieties may bind to a first type of target homologues which are specific for the first type of target moiety. A first sensor signal which is representative for the amount of first type of magnetic particles 4a bound to the sensor substrate surface 5 may be provided by the GMR element 8a. The first type of magnetic particles 4a may then be removed from the sensor substrate surface 5 by switching off the magnetic field generated by the actuation coil 7a, and/or by performing a washing step by switching on actuation coil 7b.

In a next step, the control means is appropriately steered, e.g. flowing of current through current wire 6b is switched off, for selectively releasing the second type of magnetic particles 4b with attached thereto the second type of target moieties. The actuation coil 7a is turned on for generating a magnetic field for attracting the second type of magnetic particles 4b towards the sensor substrate surface 5, hereby allowing them to bind to the second type of target homologues present at the sensor substrate surface 5. A second signal of the GMR element 8a may then be representative for the amount of second type magnetic particles 4b bound to the sensor substrate surface 5.

According to other embodiments, the control means may be appropriately steered, e.g. flowing of current through the second current wire 6b may be switched off, and the second type of magnetic particles 4b may be attracted to the sensor substrate surface 5 to bind to the second type of target homologues while the first type of magnetic particles 4a are still bound to the sensor substrate surface 5. Because target homologues are generally provided in excess with respect to an expected concentration of target moieties, there will always be enough target homologues left for binding the second target moiety even if some of the first type of magnetic particles 4a have erroneously bound to the second type of target homologues. Binding of the second type of magnetic particles 4b to the sensor substrate surface 5 will then change the sensor signal. It has to be noted that during binding of the second type of magnetic particles 4b to the sensor substrate surface 5 cross-reactivity may also occur with the first target homologue present at the sensor substrate surface 5 in case not all first target homologues would have been taken by the first type of magnetic particles 4a. The value of the change of the sensor signal is then a measure for the amount of second type of magnetic particles 4b bound to the sensor substrate surface 5.

According to embodiments of the present invention, however, the sensor cartridge 10 may comprise a same number of regions 2, 3 in the reaction chamber 1 as it comprises GMR elements 8a, 8b,.... For example, when a first and a second region 2, 3 are provided in the reaction chamber 1 comprising respectively a first and second type of magnetic particles 4a, 4b, according to these embodiments a first and second GMR element 8a and 8b may be provided in the sensor substrate 8 (see Fig. 2). The sensor substrate surface 5 may then comprise a first type of target homologues for specifically binding the first type of target moieties at the location of the first GMR element 8a and may comprise a second type of target homologues for specifically binding the second type of target moieties at the location of the second GMR element 8b. According to these embodiments, the control means may be appropriately steered, e.g. flowing of current through current wire 6a may first be switched off, for selectively releasing the first type of magnetic particles 4a into the reaction chamber 1. When the actuation coil 7a is switched on, the first type of magnetic particles 4a with attached thereto the first type of target moieties will be attracted towards the sensor substrate surface 5 and will allow binding of the first type of magnetic particles 4a to the first type of target homologues. The magnetic particles 4a will also be magnetized because of this magnetic field and the first GMR element 8a will provide a sensor signal representative for the amount of first magnetic particles 4a bound to the sensor substrate surface 5 at the location of the first GMR element 8a. However, at the same time also the second GMR element 8b will provide a sensor signal representative for the amount of first type of magnetic particles 4a erroneously or cross-reactively bound to the second type of target homologues present at the sensor substrate surface 5 at the location of the second GMR element 8b. This signal will further be referred to as partial signal of the second GMR element 8b. Next, the control means may be appropriately steered, e.g. flowing of current through current wire 6b may be switched off, for selectively releasing the second type of magnetic particles 4b from the second region 3 into the reaction chamber 1. After switching on the actuation coil 7a, the second type of magnetic particles 4b with attached thereto the second type of target moieties are attracted towards the sensor substrate surface 5 where they can bind to the second type of target homologues at the location of the second GMR element 8b. The sensor signal of the second GMR element will change depending on the amount of second type of magnetic particles 4b bound to the sensor substrate surface 5. This sensor signal will be referred to as the total signal of the second GMR element 8b. The difference between the total signal of the second GMR element 8b and the partial signal of the second GMR element 8b will be a measure for the amount of second type of magnetic particles 4b bound to the sensor substrate surface 5.

According to these embodiments, the occurrence of cross-reactivity can be measured (in a sequential way) and can be compensated for using a proper algorithm.

It has to be understood that, according to the above described embodiments, the sensor cartridge 10 comprising a first and second region 2, 3 is only an example and is not intended to limit the invention in any way. The reaction chamber 1 of the sensor cartridge 10 according to embodiments of the invention may comprise any suitable number of regions 2, 3. The number of regions present in the reaction chamber 1 may be equal to the number of different types of target moieties present in the sample fluid.

Furthermore, the sensor cartridge 10 may comprise any number of sensor elements, e.g. GMR elements 8a, 8b. Preferably, as already discussed, the number of sensor (e.g GMR) elements 8a, 8b may be equal to the number of regions 2, 3 in the reaction chamber 1, and thus to the number of different types of target moieties present in the sample fluid. Moreover, the sensor cartridge 10 may comprise more than two control means, one for each of the plurality of regions 2, 3 provided in the reaction chamber 1.

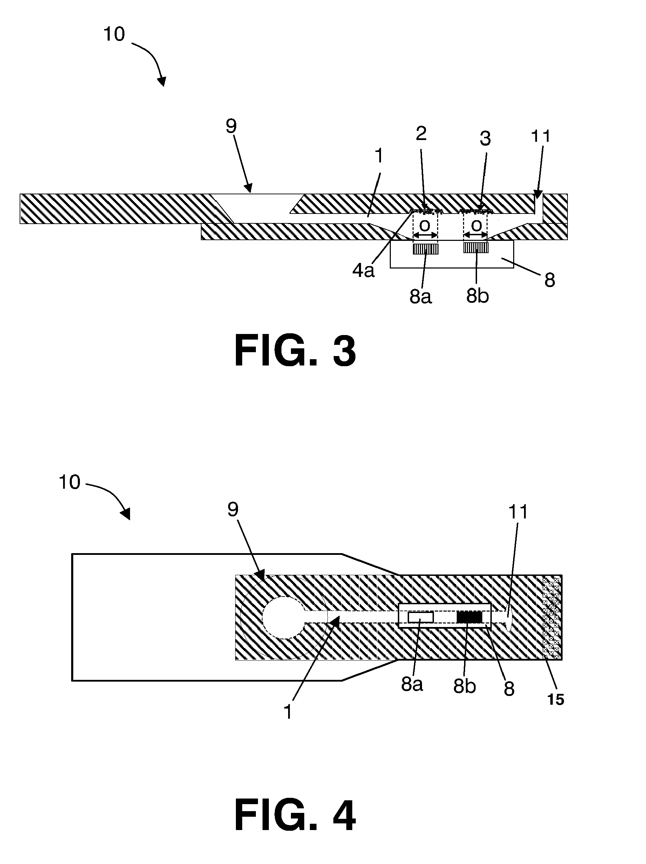

According to a second embodiment of the invention, the sensor cartridge 10 may show a resulting signal which does not substantially suffer from distortion due to cross-reaction as, according to this embodiment, the possibility for cross-reaction may be decreased and/or minimised by the configuration of the sensor cartridge 10 itself. According to this embodiment, the sensor cartridge 10 may comprise a same number of regions 2, 3 present in the reaction chamber 1 as it comprises GMR elements 8a, 8b,..... According to this second embodiment, distinct determination of the presence and/or amount of the first and second type of target moieties may be obtained by the fact that different regions 2, 3 comprising different types of magnetic particles 4a, 4b for specifically binding different types of target moieties may be located substantially above corresponding GMR elements 8a, 8b comprising different types of target homologues for specifically binding the different types of target moieties. With "substantially above" is meant that the different regions 2, 3 show an overlap O with the corresponding GMR element 8a, 8b, the overlap O being defined by the projection of the regions 2, 3 onto the relevant GMR element 8a, 8b in, when the GMR elements 8a, 8b are lying in a plane, a direction substantially perpendicular to the plane of the GMR elements 8a, 8b. Preferably, the overlap O between the regions 2, 3 and the corresponding GMR element 8a, 8b may be such that at least 80%, preferably at least 90%, more preferably at least 95 % and most preferably 100% of the region 2, 3 overlaps with the corresponding GMR element 8a, 8b. The principle of the second embodiment is illustrated in Fig. 3 and 4 which respectively show a cross-section and a top view of the sensor cartridge 10 according to the present embodiment of the present invention. The small squares 15 at the right hand side of Fig. 4 indicate electrical contacts to connect the sensor substrate 8 to a (portable) reader device.

Again, in this second embodiment and similar to the first embodiment, the different kind of magnetic particles 4a, 4b may be provided on a side of the reaction chamber 1 substantially opposite to the side of the reaction chamber 1 where the GMR elements 8a, 8b are located. Furthermore, according to this second embodiment, the different types of magnetic particles 4a, 4b may, similar to the first embodiment, most preferably be provided in a lyophilised form. According to other embodiments, the different types of magnetic particles 4a, 4b may be provided in a porous layer or in a plurality of porous layers.

The sensor cartridge 10 may furthermore comprise an inlet 9 for providing sample fluid to the reaction chamber 1 and an outlet 11 for removing the sample fluid from the reaction chamber 1 after a test has been performed or for release of air when the sensor cartridge 10 is filled with sample fluid.

Upon actuation of the bottom coil 7a (not shown in this figure, but similar to the embodiments illustrated in Fig. 1 and 2) the different types of magnetic particles 4a, 4b may be released from their respective regions 2, 3 and may be directed towards the sensor substrate surface 5. The sensor substrate surface 5 may comprise a first type of target homologues at the location of the first GMR element 8a, a second type of target homologues at the location of the second GMR element 8b, .... A further magnetic coil 7b may be present at the top of the sensor cartridge 10, similar as in the embodiments shown in Fig. 1 and 2, to achieve a bound-free separation after incubation of the magnetic particles 4a, 4b on the sensor substrate surface 5 in a magnetic washing step, or in other words to remove non-specifically bound magnetic particles 4a, b4 from the sensor substrate surface 5.

According to this second embodiment, cross-reaction may be reduced because the number of magnetic particles 4a, 4b that diffuse away from the corresponding sensor element 8a, 8b, ... will be small.

The average diffusion length or distance x that a magnetic particle 4a, 4b travels in a certain time t is given by:

$$x = 2\sqrt{\frac{Dt}{\pi}} \qquad\qquad (1)$$

For example, a magnetic particle with a diameter of e.g. 300 nm may travel on average 10,5 $\mu$m due to Brownian motion.

Therefore, preferably, the distance between neighbouring regions 2, 3 may be between 10 $\mu$m and 1000 $\mu$m, more preferably between 50 $\mu$m and 500 $\mu$m and most preferably between 100 $\mu$m and 250 $\mu$m for particles with a diameter or size of 300 nm in samples with viscosity in the range of 1 mPa in order to avoid the first type of magnetic particles 4a to bind to the second GMR element 8a and vice versa (see further). It has to be noted that the diffusion length depends on the particle size and on the viscosity of the sample fluid. For example, when magnetic particles 4a, 4b larger than 300 nm are used the diffusion length will be smaller than the 10,5 $\mu$m as calculated above.

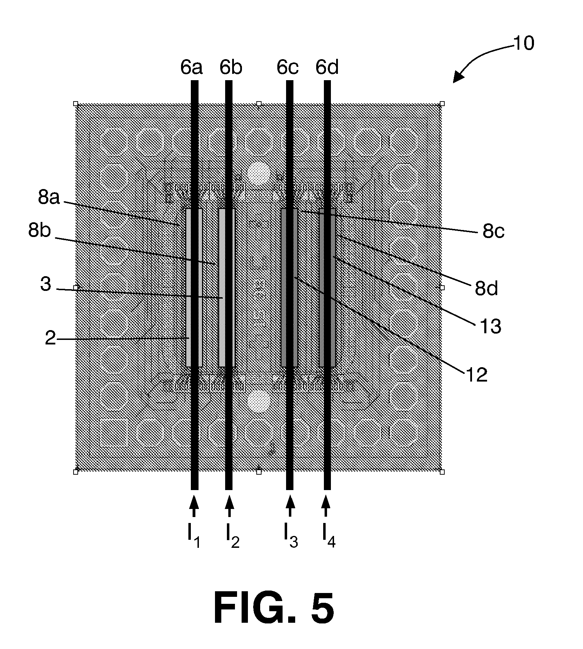

According to the second embodiment, the cross-reactivity can be further reduced by providing control means for each of the regions 2, 3. As explained in the first embodiment, the control means may, for example, be magnetic field generating means such as e.g. a current wire. This is illustrated in Fig. 5 which illustrates a top view of a sensor cartridge 10 according to the second embodiment of the present invention. According to the example given in Fig. 5, the sensor cartridge 10 may comprise four regions 2, 3, 12, 13 and may comprise four sensor elements, e.g. GMR elements 8a-d, such that the regions 2, 3, 12, 13 are located substantially above the corresponding sensor elements, e.g. GMR elements 8a-d as described earlier. The sensor cartridge 10 according to this example furthermore comprises four control means, in the example illustrated current wires 6a-d, one current wire 6a or 6b or 6c or 6d for each of the regions 2, 3, 12, 13. The current wires 6a-d can be placed in a top cover of the reaction chamber 1 at a side opposite to the sensor side of the reaction chamber 1, or in other words opposite to the side of the reaction chamber 1 where the sensor elements 8a-d are located. These current wires 6a-d may be aligned with the sensor elements, e.g. GMR elements 8a-d. The different types of magnetic particles 4a, 4b may be provided in regions 2, 3, 12, 13 at a side of the reaction chamber 1 opposite to the side of the reaction chamber 1 where the sensor elements, e.g. GMR elements 8a-d are provided, as was already discussed in the first embodiment and as already mentioned before in this embodiment.

It has to be noted that the force due to the local field gradient of the current wires 6a-d corresponding to the first to fourth region 2, 3, 12, 13 must be stronger than the force due to the actuation field applied from the bottom, because otherwise retention of magnetic particles 4a, 4b in some regions (e.g. region 3, 12, 13) will not be possible when releasing magnetic particles 4a, 4b from one region (e.g. region 2) and attracting them to the sensor substrate surface 5.

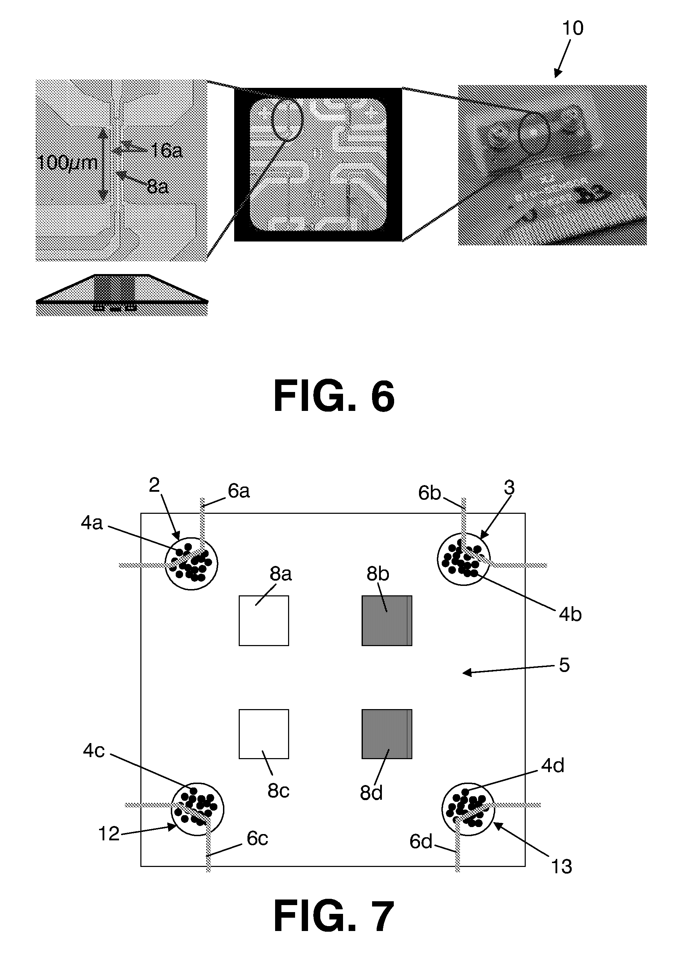

Fig. 6 illustrates a sensor cartridge 10 (right figure), a sensor substrate 8 comprising four GMR elements 8a-d and four current wires 16a-d (middle figure) and part of the sensor substrate 8 comprising one GMR element 8a and one current wire 6a. Note that these current wires 16a-d are used to magnetize the magnetic particles 4a, 4b for detection. In this design the current wires 16a-d are not intended for a controlled release of magnetic particles 4a, 4b. Generally the magnetic particle-retention wires 6a-d are located at the other side of the reaction chamber. The sensor substrate 8 may however comprise additional wires 6a-d that implement magnetic particle retention and controlled release. In one possible embodiment these wires 6a-d may be separated from the excitation wires 16a-d needed for detection. In a further embodiment these wires 6a-d may be the same as wires 16a-d.

The flow of the sample fluid can, according to different embodiments, either be parallel to the current wires 6a-d and the GMR elements 8a-d or can be perpendicular to the current wires 6a-d and the GMR elements 8a-d. According to one embodiment the fluid-flow may be aligned with the sensor elements 8a-d and the current wires 6a-d. According to this embodiment sub-channel structures may be present that are aligned with the current wires 6a-d. Each of the different types of magnetic particles 4a, 4b can then be positioned in one of the sub-channels present in the fluidic chamber 1.

In the above-described embodiments, the current wires 6a-d for selectively releasing the different types of magnetic particles 4a, 4b from their respective regions 2, 3, 12, 13 are located inside a disposable part of the sensor cartridge 10. This may be a disadvantage. It has therefore to be noted that, according to embodiments of the invention, the magnetic field generation means (e.g. current wires 6a-d) for selectively releasing the different types of magnetic particles 4a, 4b from their respective regions 2, 3, 12, 13 may also be located in a non-disposable reader device.

It has to be noted that, according to other embodiments, alternatively the regions 2, 3, 12, 13 may be regions 2, 3, 12, 13 located on the sensor substrate surface 5 outside the actual detection region around the sensor elements 8a-d. Hence, according to these embodiments, the regions 2, 3, 12, 13 may be located at a same side of the reaction chamber 1 as where the sensor elements, e.g. GMR elements 8a-d are located. The sensor cartridge 10 according to these embodiments may comprise control means for releasing different types of magnetic particles 4a, 4b from the regions 2, 3, 12, 13 and the release of different types of magnetic particles 4a, 4b may be similar to the release of the magnetic particles 4a, 4b as described for the first and second embodiments.

According to a third embodiment of the invention the control means or magnetic field generating means, e.g. current wires, may be integrated into the sensor substrate 8 in which the sensor elements, e.g. GMR elements 8a-d. are located, also referred to as GMR sensor die 8. According to this embodiment, the different types of magnetic particles 4a, 4b, 4c, 4d may be locally applied on or next to the sensor elements, e.g. GMR elements 8a-d, for example, by means of ink-jet printing. This is illustrated in Fig. 7. Hence, a first type of magnetic particles 4a is provided to the sensor substrate surface 5 at or next to the location of a first sensor element, e.g. GMR element 8a, the second type of magnetic particles 4b may be provided to the sensor substrate surface 5 at or next to the location of a second sensor element, e.g. GMR element 8b, the third type of magnetic particles 4c may be provided to the sensor substrate surface 5 at or next to the location of a third sensor element, e.g. GMR element 8c, the fourth type of magnetic particles 4d may be provided to the sensor substrate surface 5 at or next to the location of a fourth sensor element, e.g. GMR element 8d, etc. Hence, according to this third embodiment, the first, second, ... region 2, 3, 12, 13 may be located at a same side of the reaction chamber 1 as where the GMR elements 8a-d are located.

Distinct determination of the presence and/or amount of the first, second, ... type of target moieties, according to this third embodiment, may be obtained by the presence of a control means for selectively releasing the first type of magnetic particles 4a, the second type of magnetic particles 4b, ... from respectively the first region 2, the second region 3, ... into the reaction chamber 1. This may be obtained by a control means, e.g. magnetic field generating means such as current wires, for selectively releasing the different types of magnetic particles 4a, 4b, 4c, 4d from their respective regions 2, 3, 12, 13. The current wires 6a-d needed for the selective release of magnetic particles 4a, 4b, 4c, 4d can also be used for actuation during the printing process. In this way, magnetic particles 4a, 4b, 4c, 4d can be transported to correct positions when the current wires 6a-d are activated during application of the magnetic particles 4a, 4b, 4c, 4d. The time between the release of the magnetic particles 4a, 4b, 4c, 4d and subsequent attraction towards the sensor substrate surface 5 can range between 0 and 600 seconds and may preferably be between 1 and 50 seconds.

An advantage of this embodiment is that it can be implemented easily since the wires are 6a-d integrated in the sensor die, e.g. GMR sensor die 8. A disadvantage, however, of this method is that the magnetic particles 4a, 4b, 4c, 4d do not come into contact with the full sample volume. Hereby the pre-incubation of the target moieties, which has been shown to be necessary for reproducibility of tests in the case of drug detection, from the sample with the labelled antibodies is less effective.

The sensor cartridge 10 and the methods according to embodiments of the present invention may be advantageously used in biological assays. The use of magnetic labels in biological assays is favourable for many reasons:

- The magnetic particles 4a, 4b can be redispersed from a dry form in the sample fluid. Redispersion can, for example, be improved by magnetically agitating the magnetic particles 4a, 4b. Redispersion of the magnetic particles 4a, 4b throughout the sample volume speeds up the biological reaction because diffusion distances are kept small.
- The magnetic particles 4a, 4b bound to target molecules can be attracted to the sensor surface 5, thereby increasing the target concentration at the sensor surface 5. Again the magnetic particles 4a, 4b can be agitated using magnetic fields in order to improve biological binding.
- The magnetic particles 4a, 4b that did not specifically bind to the sensor surface 5 can be 'washed-off' by, for example, pulling them away from the sensor surface 5 via magnetic fields. The magnetic pulling can be controlled accurately leading to low variations in the assay results. Furthermore, it eliminates the need for complex fluidic washing steps.

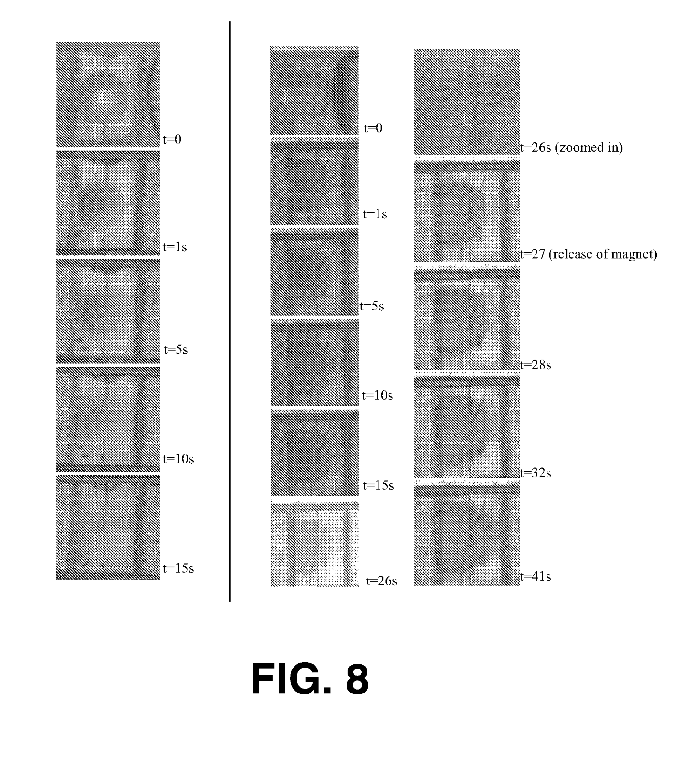

In Fig. 8 images of magnetic particle redispersion at different time instants are shown. The images at the left show magnetic particle redispersion when the magnetic particles are brought into contact with a fluid without application of magnetic retention fields. The images at the middle and right show images during magnetic particle redispersion in the presence of a retention field according to embodiments of the present invention. These figures show that without application of retention fields the magnetic particles 4a-d redisperse fast i.e. within 15 seconds, while with the application of retention fields the magnetic particles 4a-d are kept at their initial location for a long time, i.e. at least up to 27 seconds. One image (at t=26, first image at right side) shows a zoom from which it can be observed that the magnetic particles form chains along the magnetic field lines of the applied retention field. The images in this figure prove the possibility to control the redispersion of magnetic particles 4a-d from a dry state by applying the idea of the present invention.

Distinctive detection of a first and second target moiety present in a sample fluid according to an embodiment of the invention may be performed by:

- providing the sample fluid to the reaction chamber 1,
- releasing the first type of magnetic particles 4a from the first region 2 into the reaction chamber 1,
- optionally incubating for some time, typically ranging from 10 seconds to 600 seconds, so that the first target moiety can bind to an antibody of the first type of magnetic particles 4a,
- applying a magnetic field gradient for attracting the first type of magnetic particles 4a with attached thereto the first type of target moiety toward the sensor substrate surface 5,
- incubating for some time, so that magnetic particles 4a that do not carry the target moiety are able to bind to the first type of target homologue on the sensor substrate surface 5,
- remove unbound magnetic particles by applying suitable actuation fields,
- measuring a sensor signal representative for the amount of first type of magnetic particles 4a bound to the sensor substrate surface 5,
- determining from the sensor signal the presence and/or concentration of first - target moiety present in the sample fluid,
- optionally washing away the bound first type of magnetic particles 4a,
- releasing the second type of magnetic particles 4b from the second region 3 into the reaction chamber 1,
- optionally incubating for some time, so that the target moiety can couple to an antibody on the second type of magnetic particles 4b,
- applying a magnetic field gradient for attracting the second type of magnetic particles 4b with attached thereto the second type of target moieties toward the sensor substrate surface 5,
- optionally incubating for some time, so that the second type of magnetic particles 4b can bind to the second target homologue on the sensor substrate surface 5,
- wash away the unbound magnetic particles 4b,
- measuring a sensor signal representative for the amount of second type of magnetic particles 4b bound to the sensor substrate surface 5, and

- determining from the sensor signal the presence and/or concentration of the second target moiety present in the sample fluid.

According to embodiments of the invention, in addition to molecular assays, also larger moieties can be detected, e.g. cells, viruses, or fractions of cells or viruses, tissue extract, etc. Detection can occur with or without scanning of the sensor elements 8a-d with respect to the sensor substrate surface 5.

Measurement data can be derived as an end-point measurement, as well as by recording signals kinetically or intermittently.

The sensor cartridge 10 according to embodiments of the present invention can be used with several biochemical assay types, e.g. binding/unbinding assay, sandwich assay, competition assay, displacement assay, enzymatic assay, etc.

The sensor cartridge 10 according to embodiments of this invention are suitable for sensor multiplexing (i.e. the parallel use of different sensors and sensor surfaces), label multiplexing (i.e. the parallel use of different types of labels or magnetic or magnetizable objects 4a, 4b) and chamber multiplexing (i.e. the parallel use of different reaction chambers).

The sensor cartridge 10 according to embodiments of the present invention can be used as rapid, robust, and easy to use point-of-care biosensors for small sample volumes. The reaction chamber can be a disposable item to be used with a compact reader, containing the one or more magnetic field generating means and one or more detection means. Also, the sensor cartridge 10 according to embodiments of the present invention can be used in automated high-throughput testing. In this case, the reaction chamber may, for example, be a well plate or cuvette, fitting into an automated instrument.

A specific example in which the sensor cartridge 10 according to embodiments of the present invention may be used is for the detection of drugs-of-abuse in saliva. For example, the sensor cartridge 10 may be used in traffic (similar to a breath control test) and must be able to verify the presence of up to five drugs in a signal saliva sample within, for example, 1 minute. It is clear that for this purposes the test should be reliable and easy to use.

It is to be understood that although preferred embodiments, specific constructions and configurations, as well as materials, have been discussed herein for devices according to the present invention, various changes or modifications in form and detail may be made without departing from the scope and spirit of this invention.

## Claims

1.  A sensor cartridge (10) for determining the presence and/or amount of at least two different target moieties present in a sample fluid, the sensor cartridge (10) comprising:

    - a reaction chamber (1) for receiving the sample fluid,
    - at least a first region (2) and a second region (3) located in the reaction chamber (1), the second region (3) being distinct from the first region (2), the first region (2) comprising magnetic or magnetizable objects labelled with a first type of probes for specifically binding a first type of target moieties and the second region (3) comprising magnetic or magnetizable objects labelled with a second type of probes for specifically binding a second type of target moieties, the magnetic or magnetizable objects in the first and second region (2, 3) being directly contactable by the sample fluid, and
    - at least one sensor element (8a) for sensing the presence of magnetic or magnetizable objects (4a, 4b),

    wherein the sensor cartridge (10) is adapted for distinctively detecting the at least two different target moieties.

2.  A sensor cartridge (10) according to claim 2, wherein the sensor cartridge (10) comprises control means (6a-d) for selectively releasing labelled magnetic or magnetizable objects (4a, 4b) from the at least first and second region (2, 3) in the reaction chamber (1).

3.  A sensor cartridge (10) according to claim 3, wherein the control means (6a-d) is formed by a magnetic field generating means.

4.  A sensor cartridge (10) according to claim 3, wherein the magnetic field generating means is formed by at least one current wire.

5.  A sensor cartridge (10) according to any of claims 2 to 4, the sensor cartridge (10) comprising a plurality of regions (2, 3, 12, 13), wherein a control means (6a-d) is provided for each region (2, 3, 12, 13).

6. A sensor cartridge (10) according to any of claims 2 to 5, the at least one sensor element (8a) being located at a first side of the reaction chamber (1), wherein the at least first and second region (2, 3, 12, 13) are formed at a second side of the reaction chamber (1), the second side being substantially opposite to the first side.

7. A sensor cartridge (10) according to any of claims 2 to 6, the sensor cartridge (10) comprising a number of regions (2, 3, 12, 13) and a number of sensor elements (8a, 8b) wherein the number of regions (2, 3, 12, 13) is different from the number of sensor elements (8a, 8b).

8. A sensor cartridge according to any of claims 2 to 6, the sensor cartridge (10) comprising a number of regions (2, 3, 12, 13) and a number of sensor elements (8a-d), wherein the number of regions (2, 3, 12, 13) is equal to the number of sensor elements (8a-d).

9. A sensor cartridge (10) according to claim 8, the sensor elements (8a, 8b) lying in a plane, wherein the each of the regions (2, 3) shows an overlap (O) with a respective sensor element (8a, 8b), the overlap (O) being defined by the projection of the regions (2, 3) onto the sensor elements (8a, 8b) in a direction substantially perpendicular to the plane of the sensor elements (8a, 8b).

10. A sensor cartridge (10) according to any claims 1 to 5, the at least one sensor element (8a) being located at a first side of the reaction chamber (1), wherein the at least first and second region (2, 3, 12, 13) are formed at a second side of the reaction chamber (1), the second side being equal to the first side.

11. A sensor cartridge (10) according to claim 10, the sensor cartridge (10) comprising at least a first and second sensor element (8a, 8b), wherein the first region is formed on the first sensor element (8a) and the second region is formed on the second sensor element (8b).

12. A sensor cartridge (10) according to any of the previous claims, wherein the labelled magnetic or magnetizable objects (4a, 4b) in the at least first and second region (2, 3) are lyophilised.

13. A sensor cartridge (10) according to any of the previous claims, wherein the sensor cartridge (10) is a disposable sensor cartridge.

14. A sensor cartridge (10) according to claim 13, the disposable sensor cartridge (10) being adapted for being inserted in a reader device, the reader device comprising magnetic field generating means for attracting and releasing magnetic or magnetizable objects (4a,4b) located in different regions (2,3) of the disposable sensor cartridge (10) in a controlled way.

15. A sensor cartridge (10) according to claim 14, wherein the field generating means is formed by an electromagnetic coil.

16. Use of a sensor cartridge (10) according to any of claims 1 to 15 in molecular diagnostics, biological sample analysis or chemical sample analysis.

17. Use of a sensor cartridge (10) according to any of claims 1 to 15 for determining the presence of drugs-of-abuse in saliva.

18. Method for manufacturing a sensor cartridge (10), the method comprising:

   - providing a reaction chamber (1) for receiving a sample fluid,
   - providing at least a first region (2) and a second region (3) in the reaction chamber (1), and
   - providing magnetic or magnetizable objects (4a, 4b) labelled with a first type of probes for specifically binding a first type of target moieties to the first region (2) and providing magnetic or magnetizable objects (4a, 4b) labelled with a second type of probes for specifically binding a second type of target moieties to the second region, and
   - providing at least one sensor element (8a) for sensing the presence of magnetic or magnetizable objects (4a, 4b).

19. Method according to claim 18, wherein the method furthermore comprises providing control means (6a-d) for selectively releasing labelled magnetic or magnetizable objects (4a, 4b) from the at least first and second region (2, 3) in the reaction chamber (1).

20. Method according to claim 19, wherein providing control means (6a-d) comprises providing a control means (6a-d) for each of the at least first and second regions (2, 3).

21. Method according to any of claims 18 to 20, the sensor cartridge (10) comprising at least a first and a second sensor element (8a, 8b) lying in a plane, wherein providing at least a first region (2) and a second region (3) in the reaction chamber (1) is such that the first and second region (2, 3) show an overlap (O) with respectively the first and second sensor element (8a, 8b), the overlap (O) being defined by the projection of the first and second regions (2, 3) onto the sensor elements (8a, 8b) in a direction substantially perpendicular to the plane of the sensor elements (8a, 8b).

22. Method according to any of claims 18 to 21, wherein providing magnetic or magnetizable objects (4a, 4b) is performed by providing lyophilised magnetic or magnetizable objects.

23. Method for determining the presence and/or amount of at least two different target moieties in a sample fluid, the method comprising:

- providing a sample fluid comprising at least two different target moieties to a sensor cartridge (10) comprising a reaction chamber (1) for receiving the sample fluid, at least one sensor element (8a) located in a sensor substrate (8) for sensing the presence of magnetic or magnetizable objects (4a, 4b) and at least a first region (2) and a second region (3) located in the reaction chamber (1), the second region (3) being distinct from the first region (2), the first region (2) comprising magnetic or magnetizable objects (4a) labelled with a first type of probes for specifically binding a first type of target moieties and the second region (3) comprising magnetic or magnetizable objects (4b) labelled with a second type of probes for specifically binding a second type of target moieties, the magnetic or magnetizable objects (4a, 4b) in the first and second region (2, 3) being directly contactable by the sample fluid,
- selectively providing labelled magnetic or magnetizable objects (4a, 4b) from the at least first and second region (2, 3) to the at least one sensor element (8a),
- measuring a sensor signal by means of the at least one sensor element (8a), and
- from the measured sensor signal distinctively determining the presence and/or amount of the at least two different target moieties bound to a surface (5) of the sensor substrate (8).

24. Method according to claim 23, wherein selectively providing labelled magnetic or magnetizable objects (4a, 4b) from the at least first and second region (2, 3) to the at least one sensor element (8a) is obtained by selectively releasing labelled magnetic or magnetizable objects (4a, 4b) from the at least first and second region (2, 3) in the reaction chamber (1).

25. Method according to claim 23, the sensor cartridge (10) comprising a same number of regions (2, 3) as it comprises sensor elements (8a, 8b) and the sensor elements (8a, 8b) lying in a plane, wherein selectively providing labelled magnetic or magnetizable objects (4a, 4b) from the at least first and second region (2, 3) to the sensor elements (8a, 8b) is obtained by each region (2,3) having an overlap (O) with a different sensor element (8a, 8b), the overlap (O) being defined by the projection of the first and second regions (2, 3) onto the sensor elements (8a, 8b) in a direction substantially perpendicular to the plane of the sensor elements (8a, 8b).

26. Method according to any of claims 23 to 25, the sensor cartridge (10) comprising a magnetic sensor element, wherein the method furthermore comprises, before measuring a sensor signal by means of the at least one sensor element (8a), magnetising the labelled magnetic or magnetizable objects (4a, 4b).

27. Use of the method according to any of claims 23 to 26 in molecular diagnostics, biological sample analysis or chemical sample analysis.

**FIG. 1**

**FIG. 2**

**FIG. 3**

**FIG. 4**

FIG. 5

**FIG. 6**

**FIG. 7**

t=0

t=1s

t=5s

t=10s

t=15s

t=0

t=1s

t=5s

t=10s

t=15s

t=26s

t=26s (zoomed in)

t=27 (release of magnet)

t=28s

t=32s

t=41s

# FIG. 8

## FIG. 9 – prior art